# FASCICULE DE BREVET EUROPEEN

(11) **EP 3 993 069 B1**
(45) Date de publication et mention de la délivrance du brevet: **16.04.2025**
(21) Numéro de dépôt: 21204654.4
(22) Date de dépôt: 26.10.2021
(51) Int. Cl.: H01L 33/22, H01L 33/38, H01L 25/075

(54) **DIODE ÉLECTROLUMINESCENTE À STRUCTURE DE CONTACT TRIDIMENSIONNELLE, ÉCRAN D'AFFICHAGE ET PROCÉDÉ DE FABRICATION ASSOCIÉ**
LICHTEMITTIERENDE DIODE MIT DREIDIMENSIONALER KONTAKTSTRUKTUR, ANZEIGE UND HERSTELLUNGSVERFAHREN DAFÜR.
LIGHT EMITTING DIODE WITH THREE DIMENSIONAL CONTACT STRUCTURE, DISPLAY AND FABRICATION PROCESS THEREOF.

(30) Priorité: 29.10.2020 FR 2011082
(43) Date de publication de la demande: 04.05.2022
(73) Titulaire: Commissariat à l'Energie Atomique et aux Energies Alternatives, 75015 Paris (FR)
(72) Inventeur: NOGUET, Dominique, 38054 GRENOBLE CEDEX 09 (FR); BEN BAKIR, Badhise, 38054 GRENOBLE CEDEX 09 (FR)
(74) Mandataire: Cabinet Camus Lebkiri

(56) Documents cités:
- KR-A- 20160 054 331
- US-A1- 2003 141 506
- US-A1- 2010 052 000
- US-A1- 2010 301 362
- US-A1- 2013 214 322

## Description

### DOMAINE TECHNIQUE DE L'INVENTION

La présente invention est relative à une diode électroluminescente, à un écran d'affichage comprenant une matrice de diodes électroluminescentes et à un procédé de fabrication associé.

### ARRIERE-PLAN TECHNOLOGIQUE

Ces dernières années ont vu le développement et le perfectionnement d'écrans d'affichage à diodes électroluminescentes, en particulier à microLEDs (dans la suite, on utilisera indifféremment l'expression « diode électroluminescente » et l'acronyme « LED » - pour « Light Emiting Diode », en anglais).

Dans un tel écran, chaque pixel comprend par exemple trois ou quatre sources élémentaires de lumière (pour obtenir un affichage en couleurs), réalisées chacune sous la forme d'une diode électroluminescente. Ces différentes diodes électroluminescentes sont pilotées électriquement de manière indépendante les unes autres pour former l'image à afficher. On notera qu'un tel écran en couleurs peut éventuellement comprendre différents écrans, chacun monochrome mais de couleurs différentes, qui permettent d'obtenir une image en couleurs en recombinant les rayonnements lumineux produits par ces différents écrans.

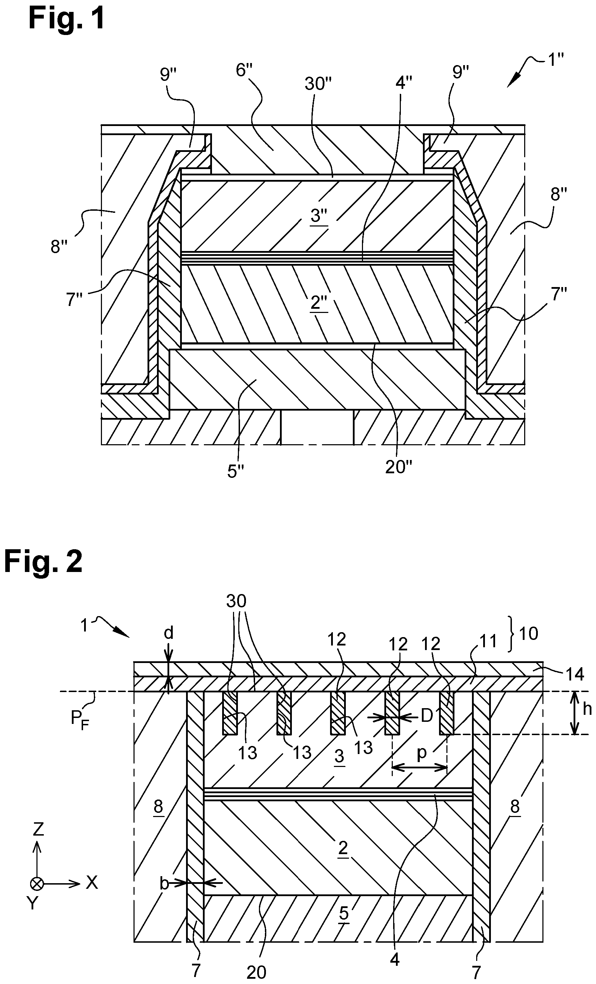

La figure 1 montre une diode électroluminescente 1" d'un tel écran à LEDs, vue en coupe, de côté.

La LED 1" comprend une couche inférieure 2", une couche supérieure 3", et, entre les deux, une couche active 4" configurée pour émettre un rayonnement lumineux lorsqu'elle est traversée par un courant électrique.

La couche inférieure 2" est par exemple une couche d'anode, réalisée au moins en partie à base d'un semi-conducteur dopé de type P, tandis que la couche supérieure 3" est une couche de cathode, réalisée au moins en partie à base d'un semi-conducteur dopé de type N. Ces deux couches 2" et 3" peuvent être réalisées chacune sous la forme d'un empilement de plusieurs sous-couches (dont certaines seulement sont dopées, par exemple), ou, au contraire, sous la forme d'une même couche d'un seul tenant. La couche active 4" comprend par exemple un empilement de puits quantiques planaires.

Le courant électrique qui alimente la LED est injecté dans la couche inférieure 2" grâce à une couche de contact 5", métallique, qui s'étend contre la face inférieure 20" de la couche inférieure 2" (face inférieure qui est plane).

Le rayonnement lumineux produit par la LED sort de ce dispositif par la face supérieure 30" de la couche supérieure 3". Cette face supérieure peut être recouverte d'une couche de protection 6", par exemple une couche en silice ou en alumine.

Dans un tel écran, deux LEDs voisines sont séparées latéralement l'une de l'autre par une tranchée, qui s'étend perpendiculairement (ou quasi perpendiculairement) aux couches 2", 3", 4", sur toute la hauteur des LEDs. Les faces latérales de cette tranchée sont recouvertes d'une couche 7" isolante électriquement, et la tranchée est rempli ensuite par un métal 8" qui vient déborder légèrement sur la face supérieure 30" pour assurer la connexion électrique de la couche de cathode 3". Cette structure métallique forme ainsi une paroi verticale (servant à séparer optiquement les deux LEDs l'une de l'autre) avec, à son sommet, une partie formant un rebord qui s'étend transversalement, en surplomb, pour venir recouvrir une petite portion de la face supérieure 30" afin de réaliser une patte de contact 9". Cette patte de contact 9" recouvre une partie seulement de la face supérieure 30" pour ne pas gêner la sortie du rayonnement lumineux produit.

Pour augmenter la résolution d'affichage, ou pour produire des écrans de plus en plus petits, on cherche actuellement à produire des LEDs, telles que celle décrite ci-dessus, ayant des dimensions latérales de plus en plus petites, par exemple de l'ordre de quelques microns (typiquement, inférieur à 5 microns).

Mais pour une telle LED, de dimensions microniques, le contact électrique entre la couche de contact 5" et la couche inférieure 2", ou entre la patte de contact 9" et la couche supérieure 3", est réalisé sur une aire particulièrement petite, si bien que la résistance de contact a une valeur élevée.

Cette résistance de contact élevée conduit localement à un échauffement de la LED qui entraine une diminution de ses performances. Cet effet défavorable est accentué par le fait que la densité de courant électrique est élevée, dans la zone de contact (puisque la surface de contact est réduite), ce qui réduit la qualité du contact électrique à la jonction métal-semiconducteur et potentiellement aussi la durée de vie du composant.

Cet inconvénient se manifeste à la fois au niveau de la face inférieure 20", et au niveau du contact entre la face supérieure 30" et la patte de contact 9".

Par ailleurs, dans une LED telle que celle représentée sur la figure 1, l'efficacité d'extraction est souvent faible : seule une petite portion de la puissance lumineuse émise par la couche active sort finalement de la LED, notamment à cause de la valeur élevée de l'indice optique des semiconducteurs employés.

L'extraction lumineuse peut être améliorée en gravant la face supérieure 30" pour réaliser un cristal photonique en matériau diélectrique. Mais dans un tel dispositif, l'efficacité d'extraction reste néanmoins limitée, en particulier pour une LED de dimensions microniques (en effet, un cristal photonique peu étendu conduit généralement à une efficacité d'extraction limitée).

Les documents US 2013/214322 A1, US 2010/301362 A1, US 2010/052000 A1, US 2003/141506 A1 et KR 2016 0054331 A décrivent des diodes électroluminescentes dont une surface par laquelle sort une partie du rayonnement comprend des motifs en creux et forme donc une surface tridimensionnelle non-plane, ladite surface étant recouverte par une structure de contact épousant cette surface non-plane.

### RESUME

Pour résoudre au moins certains des problèmes mentionnés ci-dessus, la présente technologie propose un nouveau type de diode électroluminescente comprenant une structure de contact tridimensionnelle, non plane.

La présente technologie propose plus particulièrement une diode électroluminescente comprenant :
- une couche inférieure, formée au moins en partie d'un semi-conducteur dopé,
- une couche supérieure, formée au moins en partie d'un semiconducteur dopé, les couches inférieure et supérieure ayant des dopages de types opposés,
- une structure émissive, qui s'étend entre la couche inférieure et la couche supérieure et qui est apte à émettre un rayonnement lumineux lorsqu'elle est traversée par un courant électrique,
- la couche supérieure étant délimitée par une surface supérieure, par laquelle sort une partie au moins dudit rayonnement lumineux,
- la couche inférieure étant délimitée par une surface inférieure d'injection de charges électriques (électrons ou trous),
- la surface supérieure de la couche supérieure formant une structure tridimensionnelle non-plane présentant des motifs en creux, ladite surface étant recouverte par une structure de contact formée d'un ou plusieurs matériaux électriquement conducteurs, la structure de contact s'étendant contre ladite surface, en épousant cette surface non-plane,
- et dans laquelle, pour chacun desdits motifs, un rapport d'aspect, égal à l'extension dudit motif selon une direction perpendiculaire auxdites couches, divisée par une dimension transverse dudit motif dans un plan parallèle auxdites couches, est supérieur ou égal à 2, par exemple compris entre 2 et 4, ou entre 2 et 3,5.

La structure de contact peut en particulier remplir les motifs en creux.

Cette structure tridimensionnelle permet d'augmenter l'aire de la surface de contact sans augmenter pour autant les dimensions latérales de la LED (c'est-à-dire sans augmenter la surface occupée par la LED).

A titre d'exemple, pour une même surface occupée par la LED sur le substrat, lorsque la surface inférieure ou la surface supérieure a un profil en créneaux de rapport cyclique 1/2, et définit des rainures aussi larges que profondes, alors, l'aire de contact est deux fois plus grande que si cette surface était plane.

Cette surface de contact accrue diminue la résistance de contact et améliore la qualité du contact électrique entre la structure de contact et la couche, inférieure ou supérieure, à alimenter électriquement. De surcroit, pour un courant de fonctionnement donné, la densité de courant se voit réduite dans la même proportion que l'augmentation de surface par rapport au cas d'une structure de contact plane.

On peut prévoir que les surfaces inférieure et supérieure soient toutes deux pourvues d'une structure de contact tridimensionnelle telle que présentée ci-dessus.

En plus de diminuer la résistance de contact, cette structure de contact particulière, réalisée sur la surface supérieure, permet d'obtenir des efficacités d'extraction particulièrement élevées.

Des simulations numériques détaillées (de type FDTD, c'est-à-dire par différences finies dans le domaine temporel) montrent, à titre d'exemple, qu'une efficacité d'extraction atteignant 50% peut être obtenue dans une telle configuration, et cela même sans procéder à une optimisation poussée des paramètres de la structure de contact.

A titre de comparaison, en gravant la face supérieure de la couche supérieure et en remplissant les zones gravées avec un matériau diélectrique pour former un cristal photonique (réseau d'extraction en matériau diélectrique), on obtient au mieux une efficacité de 20 à 25% environ, après optimisation.

Le fait que l'on puisse obtenir des efficacités d'extraction meilleures avec une telle structure, en matériau conducteur, plutôt qu'avec une structure diffractive en matériau diélectrique, est assez surprenant à première vue. En effet, comme matériau conducteur, on emploie généralement un métal ou un alliage métallique, réfléchissant pour le rayonnement lumineux produit. On pourrait donc s'attendre à ce que le matériau conducteur, qui remplit les motifs en creux masque une partie du rayonnement lumineux et l'empêche de sortir de la couche supérieure de la LED en jouant en quelque sorte un rôle d'écran. D'ailleurs, on constate que les pattes de contact 9" mentionnée plus haut ont un effet défavorable sur l'efficacité d'extraction (en pratique, elles sont responsables d'une diminution de l'efficacité d'extraction de quelques pourcents, par rapport à une situation dans laquelle la surface supérieure est dégagée de tout obstacle). Pourtant, la structure de contact tridimensionnelle en question permet d'obtenir des efficacités d'extraction particulièrement élevées. Une explication possible de cet effet est que le matériau conducteur en question, qui remplit les motifs en creux, forme en fait de petites inclusions conductrices dans la partie supérieure de la couche supérieure, ces inclusions jouant le rôle de micro-antennes permettant d'extraire de la couche le rayonnement lumineux en question.

Par ailleurs, le fait que les motifs en question aient un rapport d'aspect supérieur à 2 favorise une émission directive, y compris pour une diode électroluminescente de dimension réduite (par exemple inférieure à 3 microns), comme illustré par les résultats de simulation numérique présentés plus bas.

Par ailleurs, d'un point de vue électrique, le fait que la surface supérieure soit pourvue de la structure de contact particulière mentionnée plus haut permet de réduire la résistance de contact, par rapport à une géométrie d'injection de courant telle que celle de la figure 1, et, en plus, on injecte le courant électrique de manière relativement homogène sur l'ensemble de la section de la LED (au lieu de l'injecter principalement sur les flancs de la LED), ce qui améliore encore ses performances.

La structure de contact, qui joue ainsi à la fois le rôle d'un réseau d'extraction, et celui d'une structure d'injection de charges électriques de plus grande surface, permet ainsi d'améliorer considérablement les performances de la LED.

Cette structure de contact peut comprendre :
- un premier matériau électriquement conducteur, qui remplit les motifs en creux, et
- une couche de contact formée d'un deuxième matériau électriquement conducteur qui est au moins partiellement transparent pour ledit rayonnement lumineux, la couche de contact recouvrant ladite surface supérieure et venant au contact du premier matériau électriquement conducteur.

Cette couche de contact laisse passer le rayonnement lumineux produit tout en reliant électriquement les inclusions, formées du premier matériau conducteur, permettant ainsi de connecter l'ensemble de la surface supérieure à une alimentation électrique.

Outre les caractéristiques mentionnées ci-dessus, la diode électroluminescente décrite ci-dessus peut présenter une ou plusieurs des caractéristiques complémentaires suivantes, considérées individuellement ou selon toutes les combinaisons techniquement envisageables :
- la structure de contact recouvre la majeure partie, voire la totalité de ladite surface ;
- lesdits motifs, répétés régulièrement, forment un réseau périodique de pas p ou un réseau quasi-périodique ;
- lesdits motifs forment ledit réseau périodique de pas p, et, pour chacun desdits motifs, un rapport égal à ladite dimension transverse dudit motif divisée par le pas p du réseau est compris entre 20% et 40% ;
- la diode électroluminescente occupe, dans un plan parallèle aux couches, une aire totale inférieure à 100 microns carrés, voire inférieure à 10 microns carrés ;
- le premier matériau électriquement conducteur mentionné plus haut est au moins partiellement réfléchissant pour ledit rayonnement lumineux ;
- le premier matériau est un métal ou un alliage métallique ;
- le deuxième matériau est un oxyde métallique ;
- pour ledit rayonnement lumineux, la couche de contact a un coefficient d'absorption optique en puissance inférieure à 20%, voire inférieur à 10 % ;
- la surface supérieure occupe, en projection sur un plan parallèle auxdites couches, une aire frontale totale A_{T}, les motifs en creux, occupent, en projection sur un plan parallèle auxdites couches, une aire en retrait A_{R}, et un taux de remplissage, égal à l'aire en retrait A_{R} divisée par l'aire frontale totale A_{T}, est inférieur à 50%, voire inférieur à 30% ;
- la surface supérieure, qui forme ladite structure tridimensionnelle, s'étend entre un plan avant et un plan arrière situé en retrait, les plans avant et arrière étant parallèles auxdites couches, et le premier matériau conducteur, qui remplit les motifs en creux, forme une ou des inclusions qui s'étendent au-delà dudit plan avant, jusque dans la couche de contact ;
- les inclusions en premier matériau conducteur, qui remplissent les motifs en creux, sont reliées électriquement les unes aux autres ;
- la diode électroluminescente comprend une couche anti-reflet qui s'étend sur la couche de contact ;
- la couche anti-reflet est formée d'au moins un matériau diélectrique ayant un indice optique différent de l'indice optique de la couche de contact, la couche anti-reflet étant configurée de manière à réduire le coefficient de réflexion en puissance sur la face supérieure de la couche de contact, pour ledit rayonnement lumineux, par rapport à une diode électroluminescente dépourvue de cette couche anti-reflet ;
- ladite surface supérieure et ladite surface inférieure forment chacune une structure tridimensionnelle non-plane présentant des motifs en creux, recouverte par une structure de contact telle que décrite ci-dessus ;
- chacun desdits matériaux conducteurs a une conductivité électrique, à température ambiante, supérieure ou égale à 10⁵ Siemens par mètre ;
- lesdits motifs ont, selon au moins une direction (par exemple une direction perpendiculaire auxdites couches, ou parallèle auxdites couches), une dimension (c'est-à-dire une extension, représentative de la taille du motif, telle qu'une hauteur, une largeur ou un diamètre) supérieure à 0,1 micron, voire supérieure à 0,3 micron ou même supérieure à 0,5 micron ; on notera en particulier que les motifs en questions ne correspondent pas à des irrégularités, telles qu'on peut en trouver sur des couches rugueuses ;
- les différents motifs, ou tout au moins la majorité desdits motifs ont une même forme et/ou une même taille ;
- Le nombre total de motifs est supérieur ou égal à 5, voire à 9.

La présente technologie concerne aussi un écran d'affichage comprenant une matrice de diodes électroluminescentes telles que celle décrite ci-dessus.

La présente technologie concerne également un procédé de fabrication d'une diode électroluminescente, comprenant les étapes suivantes :
- réalisation d'un empilement comprenant :
   - une couche inférieure, formée au moins en partie d'un semi-conducteur dopé,
   - une couche supérieure, formée au moins en partie d'un semiconducteur dopé, les couches inférieure et supérieure ayant des dopages de types opposés, et
   - une structure émissive qui s'étend entre la couche inférieure et la couche supérieure et qui est apte à émettre un rayonnement lumineux lorsqu'elle est traversée par un courant électrique,
- report de l'empilement ainsi réalisé sur un substrat final, la couche inférieure étant située du côté dudit substrat,
- le procédé comprenant en outre les étapes suivantes :
   - gravure d'une surface supérieure de la couche supérieure pour former une structure tridimensionnelle non-plane présentant des motifs en creux, chacun desdits motifs ayant un rapport d'aspect, égal à l'extension dudit motif selon une direction perpendiculaire auxdites couches, divisée par une dimension transverse dudit motif dans un plan parallèle auxdites couches, qui est supérieur ou égal à 2, et
   - sur la surface ainsi gravée, réalisation d'une structure de contact formée d'un ou plusieurs matériaux électriquement conducteurs, la structure de contact s'étendant contre ladite surface, en épousant cette surface non plane.

La présente technologie et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif.
La figure 1 représente schématiquement une diode électroluminescente de l'art antérieur, en coupe et vue de côté.
La figure 2 représente schématiquement une diode électroluminescente selon un premier mode de réalisation, en coupe et vue de côté.
La figure 3 représente schématiquement une partie de la diode électroluminescente de la figure 2, vue de dessus.
La figure 4 est une vue schématique partielle, de dessus, d'une diode électroluminescente selon une variante du premier mode de réalisation.
La figure 5 est une vue schématique partielle, en perspective, de la diode électroluminescente de la figure 4.
La figure 6 représente schématiquement une diode électroluminescente selon une autre variante du premier mode de réalisation, vue de dessus.
La figure 7 représente schématiquement un profil d'intensité lumineuse obtenu en champ lointain avec la diode électroluminescente de la figure 2, et un profil d'intensité lumineuse obtenu avec une diode électroluminescente similaire, mais dépourvue de la structure de contact tridimensionnelle mentionnée plus haut.
La figure 8A est un graphe illustrant l'influence d'une fraction d'occupation de motifs présents sur une face de sortie de la diode électroluminescente de la figure 2, sur une efficacité d'extraction d'un rayonnement produit dans cette diode électroluminescente.
La figure 8B rassemble, sous la forme d'un graphe bidimensionnel, plusieurs profils d'intensité lumineuse en champ lointain tel que celui de la figure 7, obtenus pour différentes valeurs de cette fraction d'occupation.
La figure 8C rassemble, sous la forme d'un graphe bidimensionnel, plusieurs profils d'intensité lumineuse en champ lointain tel que celui de la figure 7, obtenus pour des structures de contact tridimensionnelle ayant des motifs de hauteurs différentes.
La figure 8D rassemble elle aussi, sous la forme d'un graphe bidimensionnel, plusieurs profils d'intensité lumineuse en champ lointain tel que celui de la figure 7, obtenus pour des structures de contact tridimensionnelle ayant des motifs de rapports d'aspect différents.
La figure 9 représente schématiquement une diode électroluminescente selon encore une autre variante du premier mode de réalisation, en coupe et vue de côté.
La figure 10 représente schématiquement une diode électroluminescente selon un deuxième mode de réalisation, en coupe et vue de côté.
La figure 11 montre une surface inférieure de la LED de la figure 10, vue de dessous.
La figure 12 montre une surface inférieure de la LED, vue de dessous, pour une variante de la LED de la figure 10.
La figure 13 représente schématiquement un écran d'affichage, à un stade intermédiaire de sa fabrication.
La figure 14 représente schématiquement certaines étapes d'un procédé de fabrication d'un tel écran d'affichage, sous la forme d'un organigramme.
La figure 15 représente schématiquement un empilement de couches, étendues transversalement et servant de base à la fabrication d'une matrice de LEDs, telle que celle de l'écran d'affichage de la figure 13.
La figure 16 montre l'empilement de la figure 15 après une étape de gravure d'une des couches de l'empilement permettant de texturer la surface de cette couche.
La figure 17 représente schématiquement cet empilement, après la réalisation d'une structure de contact électrique tridimensionnelle venant épouser la surface texturée en question.
La figure 18 représente schématiquement l'empilement en question, après report de l'empilement de la figure 17 sur un substrat final.

### DESCRIPTION DETAILLEE

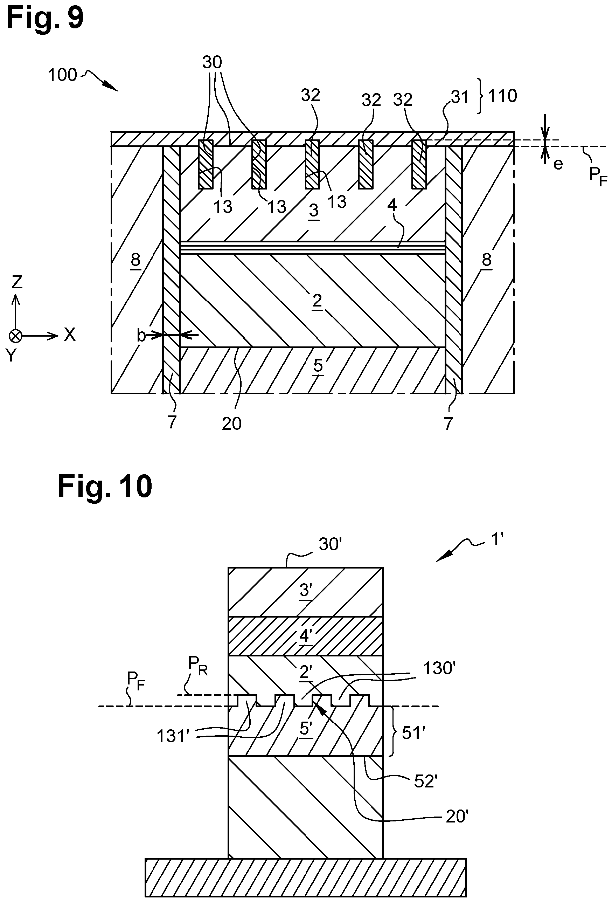

Comme indiqué plus haut, la présente technologie concerne une diode électroluminescente 1 ; 100 ; 1' comprenant une structure de contact 10 ; 5' particulière, tridimensionnelle, réalisée sur une couche inférieure 2', sur une couche supérieure 3, ou à la fois sur la couche inférieure et sur la couche supérieure de la LED afin de l'alimenter électriquement (figures 2 et 10).

Dans un premier mode de réalisation, la structure de contact en question est réalisée sur la couche supérieure de la LED. Deux variantes de la LED 1 ; 100, conformes à ce premier mode de réalisation, sont représentées schématiquement sur les figures 2 et 9.

Un deuxième mode de réalisation qui ne fait pas partie de l'invention, dans lequel c'est la couche inférieure 2' de la LED 1' qui est pourvue de cette structure de contact 5', est représenté schématiquement sur la figure 10.

Malgré quelques différences, les différentes variantes du premier mode de réalisation présentées plus bas présentent de nombreux points communs. Aussi, d'une variante à l'autre, les éléments identiques ou correspondant seront généralement repérés par les mêmes numéros de référence et ne seront pas nécessairement décrits à chaque fois. Pour le deuxième mode de réalisation, les numéros de références sont généralement accompagnés d'un prime « ' », alors qu'ils en sont dépourvus, dans le premier mode de réalisation.

La structure d'ensemble de la LED 1 ; 100 ; 1' sera présentée dans un premier temps. La structure de contact particulière 10 ; 110 ; 5' qui équipe la LED sera décrite ensuite plus en détail, pour le premier puis pour le deuxième mode de réalisation. Un écran d'affichage 1000 comprenant une matrice de LEDs 1' de ce type sera présenté ensuite, ainsi qu'un procédé de fabrication associé.

Quel que soit le mode de réalisation, la LED 1 ; 100 ; 1' comprend :
- une couche inférieure 2 ; 2', formée au moins en partie d'un semi-conducteur dopé, c'est-à-dire dopé intentionnellement,
- une couche supérieure 3 ; 3', formée au moins en partie d'un semiconducteur dopé, les couches inférieure et supérieure ayant des dopages de types opposés, et
- une structure émissive 4 ; 4' qui s'étend entre la couche inférieure 2 ; 2' et la couche supérieure 3 ; 3' et qui est apte à émettre un rayonnement lumineux lorsqu'elle est traversée par un courant électrique.

Ici, la structure émissive 4 ; 4' est réalisée sous la forme d'une couche active comprenant un empilement d'un ou plusieurs puits quantiques planaires. Par « puit quantique planaire » on désigne ici une structure comprenant :
- une couche centrale, mince (épaisseur de l'ordre de la dizaine de nanomètre), formée d'un premier matériau semi-conducteur, et
- deux couches barrières qui enserrent la couche centrale, formée d'un autre matériau semiconducteur qui a une bande interdite plus large que la bande interdite du premier matériau.

La couche centrale, mince, forme ainsi un puit de potentiel pour les électrons et/ou les trous.

A titre d'exemple, pour une émission dans le bleu, la couche centrale peut être réalisée en nitrure d'indium-gallium InGaN, tandis que les couches barrières sont réalisées en nitrure de gallium GaN. Et pour une émission dans le rouge on pourra par exemple réaliser la couche centrale et les couches barrières en Phosphorure d'Indium-Gallium InGaP et en Phosphorure d'Aluminium-Indium-Galium AlInGaP. Plus généralement, lorsque l'on souhaite obtenir une émission dans le domaine du visible, on pourra réaliser la couche active à partir de matériaux semi-conducteurs III-V, c'est-à-dire comprenant un élément de la colonne V du tableau périodique des éléments (N, As, P) associé à un ou plusieurs éléments de la colonne III du tableau périodique des éléments (Ga, Al, In).

Les couches inférieures 2 ; 2' et supérieures 3 ; 3' peuvent être chacune d'un seul tenant. Par exemple, lorsque la couche active est formée de puits en InGaN/GaN, les couches inférieures et supérieures pourront être réalisées chacune sous la forme d'une couche d'un seul tenant en nitrure de gallium GaN, dopé de type N pour l'une, et dopé de type P pour l'autre.

Les couches inférieures 2 ; 2' et supérieures 3 ; 3' peuvent aussi être formées chacune par un empilement de plusieurs sous-couches. Et l'on peut prévoir que certaines seulement de ces sous-couches soient dopées. Ainsi, lorsque la couche active est formée par exemple de puits en AlInGaP/InGaP, on peut prévoir que :
- la couche inférieure 2 ; 2' comprenne une sous-couche inférieure en Arsenure de Gallium GaAs dopé de type P, ainsi qu'une sous-couche supérieure, plus épaisse, en Phosphorure d'Aluminium-Indium AlInGaP,
- la couche supérieure 3 ; 3' comprenant alors une sous-couche inférieure, épaisse, en AlInGaP, et une sous-couche supérieure plus mince, en GaAs dopé de type N.

Quoiqu'il en soit, la couche supérieure 3 ; 3' est délimitée, en partie supérieure, par une surface supérieure 30 ; 30'. C'est par cette surface que le rayonnement lumineux produit sort de la LED 1 ; 100 ; 1'. En d'autres termes, ce rayonnement lumineux traverse la surface supérieure 30 ; 30', pour sortir de la LED 1 ; 100 ; 1'.

Quant à la couche inférieure 2 ; 2', elle est délimitée, en partie inférieure, par une surface inférieure 20 ; 20' par laquelle est injecté ou par laquelle sort le courant électrique qui alimente la LED.

Les couches 2 et 3 ou 2' et 3' sont parallèle au substrat qui sert de support à la LED 1 ; 100 ; 1'.

L'empilement comprenant la couche inférieure, la structure émissive et la couche supérieure est délimité latéralement par une surface latérale, qui s'étend perpendiculairement aux couches 2, 3 ; 2', 3' et qui est recouverte par une couche isolante électriquement, 7, par exemple en silice (figure 2). La couche isolante 7 est elle-même recouverte par une couche métallique 8, réfléchissante, au moins en partie, pour le rayonnement lumineux produit. Cette couche forme une ou des parois verticales jouant un rôle de réflecteur, autour de la LED 1 ; 100 ; 1'. Elle permet aussi d'isoler optiquement une LED d'une autre, lorsque plusieurs LEDs adjacentes sont réalisées sur le même substrat.

Dans les modes de réalisation décrits ici, la LED 1 ; 100 ; 1' a des dimensions latérales microniques, la LED ayant une extension maximale inférieure à 10 microns, ou même inférieure à 3 microns, dans un plan parallèle au substrat. Les couches 2 et 3 ou 2' et 3' ont alors des dimensions latérales inférieures à 10 microns, voire inférieures à 3 microns. En pratique, ces dimensions latérales peuvent par exemple être égales à 1 ou à 2 microns. Par dimension latérale, ou par dimension transverse, on désigne une dimension de la couche considérée, par exemple une largeur, une longueur, ou un diamètre de cette couche, dans un plan parallèle au substrat.

Dans un plan parallèle au substrat, la LED 1 ; 100 ; 1' occupe alors une aire totale inférieure à 100 microns carrés, voire inférieure à 10 microns carrés. En d'autres termes, sur le substrat en question, la LED a une emprise inférieure à 100 microns carrés, voire inférieure à 10 microns carrés. Les surfaces supérieure et inférieure ont alors chacune, en projection sur ce plan, une aire totale, appelée aire frontale totale A_{T}, inférieure à 100 microns carrés, voire inférieure à 10 microns carrés.

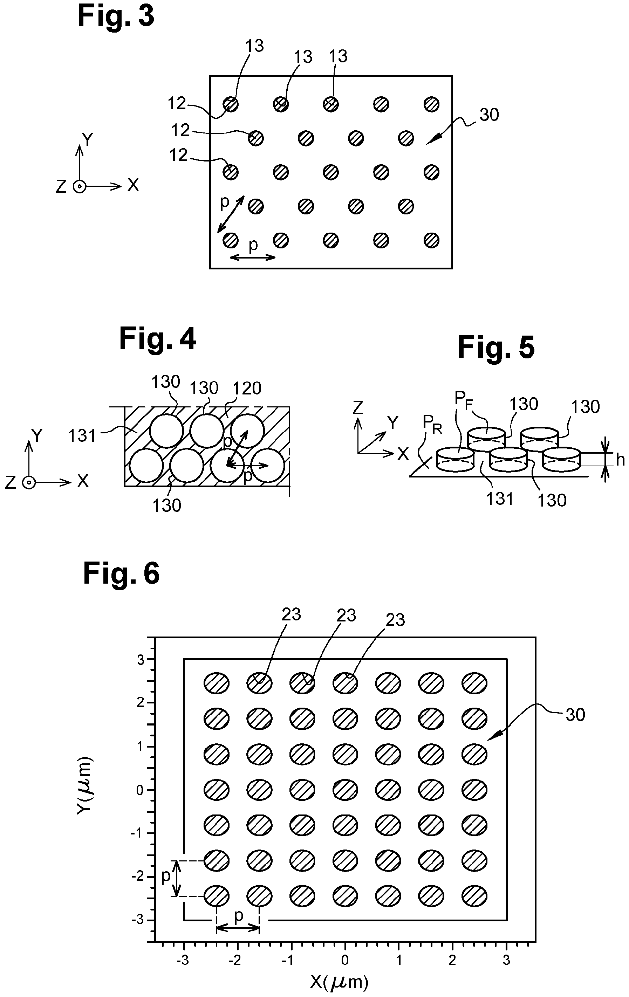

De manière remarquable, l'une au moins des deux surfaces supérieure et inférieure forme une structure tridimensionnelle non-plane présentant des motifs en creux 13 ; 23 ou en saillie 130 ; 130' (figures 3, 4 et 10). Cette surface est recouverte par la structure de contact 10 ; 110 ; 5' mentionnée plus haut. Cette structure de contact 10 ; 5' est formée d'un ou plusieurs matériaux électriquement conducteurs et elle s'étend contre la surface en question, 30 ; 20', en remplissant les motifs en creux 13 (figures 2 et 3), ou l'espace 131 ; 131' situé entre les motifs en saillie 130 ; 130' (figures 2, 3, 5, 6 et 10). Les motifs en saillie ne font pas partie de l'invention.

Cette structure tridimensionnelle permet de connecter électriquement la couche considérée (inférieure ou supérieure), sur une surface ayant une aire plus importante que l'aire frontale totale A_{T} de la couche. On augmente ainsi l'aire sur laquelle est réalisé le contact électrique (ce qui diminue d'autant la résistance de contact), sans augmenter les dimensions latérales de la LED.

En pratique, l'une au moins des deux surfaces supérieure et inférieure est gravée pour former ces motifs en creux, ou en saillie. Et le matériau électriquement conducteur, ou l'un des matériaux électriquement conducteurs qui forme la structure de contact 10 ; 110 ; 5' vient remplir les zones qui ont ainsi été gravées.

Le ou les matériaux conducteurs en question, qui servent à connecter électriquement la couche considérée, inférieure ou supérieure, afin d'alimenter électriquement la LED 1 ; 100 ; 1', ont chacun une conductivité électrique qui, à température ambiante (20 degrés Celsius), est supérieure par exemple à 10⁵ Siemens par mètre. Chacun de ces matériaux conducteurs peut avoir une structure de bande qui est celle d'un métal, d'un semi-métal, ou éventuellement d'un semi-conducteur (fortement dopé).

Dans le cas de la figure 2, les motifs sont des motifs en creux 13, en l'occurrence des trous cylindriques, répartis sur la surface supérieure 30, et remplis chacun par un premier matériau électriquement conducteur (matériau représenté par des hachures, sur la figure 3).

Les figures 4 et 5 représentent une variante du premier mode de réalisation qui ne fait pas partie de l'invention, dans laquelle les motifs sont des motifs en saillie 130, en l'occurrence de piliers cylindriques. Dans ce cas, l'espace 131 entre ces piliers est rempli par le premier matériau électriquement conducteur (matériau représenté par des hachures, sur la figure 4).

Que les motifs soient en saillie ou en creux, la surface en question (à savoir la surface supérieure, ou la surface inférieure) s'étend entre un plan avant P_{F} et un plan arrière P_{R}, situé en retrait (voir par exemple les figures 2, 5, 10). Les parties les plus en saillie de cette surface sont situées dans le plan avant P_{F} (dans le cas de la figure 10, qui montre le deuxième mode de réalisation, le plan avant P_{F} est situé en dessous du plan P_{R}, car les motifs 130' font saillie vers le bas). Ces deux plans P_{F}, P_{R} sont parallèles au plan des couches 2, 3 ; 2', 3'. Un matériau conducteur, par exemple le premier matériau conducteur mentionné ci-dessus, remplit (c'est-à-dire occupe) au moins la zone qui s'étend du plan avant P_{F} jusqu'à la surface gravée en elle-même, c'est-à-dire la zone qui s'étend du plan avant P_{F} jusqu'à la partie en retrait de cette surface. Dans le cas où les motifs sont des motifs en saillie (figures 4 et 10), c'est cette zone (qui porte la référence 131, ou 131') que l'on désigne comme « l'espace situé entre les motifs en saillie ».

Dans les modes de réalisation décrits ici, le ou les matériaux conducteurs qui forment la structure de contact 10 ; 110 ; 5' occupent :
- non seulement la zone qui s'étend du plan avant P_{F} jusqu'à la partie en retrait de la surface gravée 30 ; 20',
- mais aussi une zone située au-delà du plan avant P_{F} en question, en formant ainsi une couche de contact 11 ; 31 ; 51' qui recouvre la surface gravée en question.

Cette couche de contact 11 ; 31 ; 51' est parallèle aux autres couches de la LED.

Dans le cas où les motifs sont des motifs en creux 13 cette couche de contact 11 ; 31 permet de connecter électriquement (à une source extérieure) les inclusions 12 ; 32 de matériau conducteur qui remplissent ces motifs en creux 13, pour pouvoir injecter ou extraire des charges électriques au niveau de ces inclusions conductrices (figures 2 et 9).

Lorsque la structure de contact 10 ; 110 est réalisée sur la surface supérieure 30 (premier mode de réalisation), la couche de contact 11 ; 31 en question est formée d'un deuxième matériau conducteur qui est au moins partiellement transparent pour le rayonnement lumineux produit, afin de laisser ce rayonnement lumineux sortir de la LED 1 ; 100.

En revanche, lorsque la structure de contact 5' est réalisée sur la surface inférieure 20' (deuxième mode de réalisation), la couche de contact 51' peut très bien être opaque, ou réfléchissante pour le rayonnement lumineux produit par la LED. Dans ce cas, la structure de contact 5' peut en particulier être d'un seul tenant, le même matériau conducteur, par exemple un métal ou un alliage métallique remplissant alors les motifs en creux, ou l'espace situé entre les motifs en saillie, et débordant au-delà pour former la couche de contact 51' qui recouvre l'ensemble de la surface en question.

Le premier mode de réalisation, dans lequel la surface supérieure 30 est pourvue de la structure de contact tridimensionnelle en question, 10 ; 110, est maintenant décrit plus en détail, en référence aux figures 2 à 9.

### Premier mode de réalisation : structure de contact tridimensionnelle réalisée sur la couche supérieure de la LED

Comme déjà indiqué, dans ce mode de réalisation, les motifs en creux 13 ; 23, ou l'espace 131 entre les motifs en saillie 130, sont remplis par un premier matériau électriquement conducteur, et la couche de contact 11 ; 110, qui recouvre l'ensemble de la surface supérieure 30, est formée d'un deuxième matériau électriquement conducteur qui est au moins partiellement transparent pour le rayonnement lumineux produit. La couche de contact 11 ; 31 s'étend contre les parties saillantes (parties avant) de la surface supérieure 20, et vient aussi au contact du premier matériau conducteur (qui remplit les zones en retrait).

Pour le rayonnement lumineux produit par la LED, la couche de contact 11 ; 31 peut par exemple avoir un coefficient d'absorption, en puissance, inférieure à 20%, voire inférieur à 10 %, pour l'ensemble de la couche (ce coefficient est égal à la puissance absorbée dans la couche de contact, divisée par la puissance qui pénètre dans celle-ci). Pour le rayonnement lumineux en question, le deuxième matériau conducteur peut par exemple avoir un coefficient d'absorption (en puissance) inférieur à 0,3 par micron, voire inférieur à 0,1 par micron.

Le deuxième matériau conducteur est par exemple un oxyde métallique conducteur et transparent tel que l'ITO (« oxyde d'indium et d'étain », comprenant plus précisément de l'oxyde d'indium In₂O₃ et l'oxyde d'étain SnO₂), l'IZO (oxyde de Zinc ZnO dopé à l'Indium In), ou l'AZO (oxyde de Zinc ZnO dopé à l'Aluminium Al). Ici, ce deuxième matériau est de l'ITO.

Ici, le premier matériau conducteur est réfléchissant pour le rayonnement lumineux en question, contrairement au deuxième matériau conducteur. Son coefficient de réflexion en puissance (pour une interface qui serait plane) est par exemple supérieur à 80%, voire supérieur à 90%.

Comme les inclusions formées par ce premier matériau jouent le rôle d'antennes, permettant d'extraire le rayonnement lumineux émis par la couche active, le premier matériau a de préférence des propriétés optiques comparables à celles d'un métal (il peut d'ailleurs s'agir d'un métal). En particulier, dans le domaine de fréquences dudit rayonnement lumineux, la partie réelle de la permittivité diélectrique relative εᵣ du premier matériau est négative, et a une valeur absolue élevée, par exemple supérieure à 3, voire supérieure à 15.

Ici, le premier matériau est d'ailleurs un métal (par exemple un métal de transition), ou un alliage métallique. Le premier matériau peut par exemple être réalisé à base d'or Au, d'argent Ag, de titane Ti ou d'aluminium Al.

Les motifs en creux 13 ; 23 ou en saillie 130 peuvent, comme ici, être répétés régulièrement pour former un réseau périodique de pas p, ou un réseau quasi-périodique. Par réseau quasi-périodique, on désigne un réseau ayant une figure de diffraction formée de pics discrets (comme pour un réseau périodique), sans pour autant que le réseau soit périodique (le réseau présente une forme de régularité, mais n'est pas à strictement parler périodique).

Les inclusions métalliques 12 ; 32 qui remplissent les motifs en creux 13 (ou l'inclusion métallique 120 qui remplit l'espace 131 situé entre les motifs en saillie 130) forment ainsi un réseau métallique, qui joue alors un rôle de réseau d'extraction du rayonnement lumineux produit par la structure émissive 4. Ce réseau peut être uni- ou bi-dimensionnel.

Employer un tel agencement périodique ou quasi-périodique permet non seulement d'améliorer l'efficacité d'extraction du rayonnement lumineux produit par la structure émissive 4, mais il permet aussi de donner au faisceau lumineux extrait une forme, et éventuellement une polarisation déterminées. Ce réseau permet ainsi d'adapter le faisceau lumineux émis par la LED 1 ; 100 à l'application visée, avec beaucoup de souplesse.

Du point de vue du profil du faisceau, des simulations numériques montrent que le réseau métallique en question, permet d'obtenir une bonne directivité en champ lointain, même lorsque la surface supérieure 30 a des dimensions latérales réduites (par exemple des dimensions de l'ordre du micron).

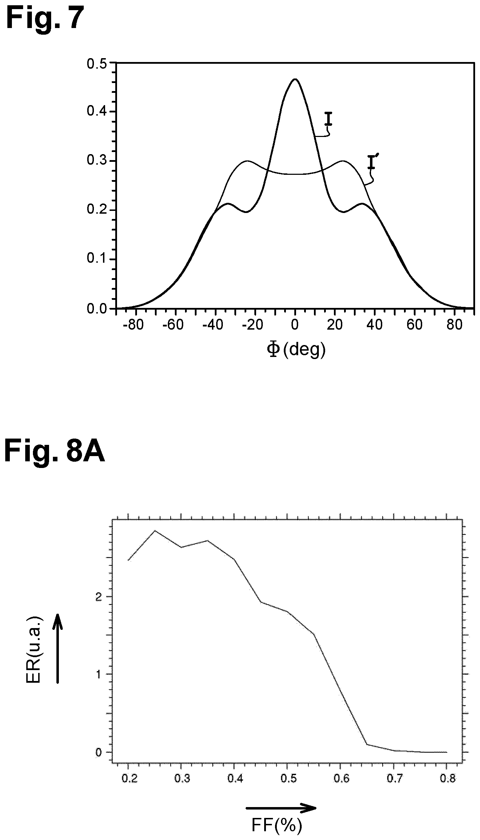

La figure 7 montre à titre d'exemple, pour la LED de la figure 2, l'évolution de l'intensité lumineuse I obtenue en champ lointain, en fonction de l'angle φ formé entre la direction de propagation considérée et un axe Z perpendiculaire aux couches 2, 3 de la LED. L'angle φ est exprimé en degrés, sur cette figure. La courbe I(φ) a été obtenue par simulation numérique, dans un cas où la surface supérieure 30 a une largeur égale à environ 1,6 fois la longueur d'onde moyenne λ du rayonnement émis (longueur d'onde moyenne dans le vide). Malgré la petitesse de la LED, on obtient une directivité satisfaisante, puisque la courbe I(φ) forme un pic dont la largeur totale à mi-hauteur est d'environ 40 degrés. Les résultats de cette simulation numérique prévoient par ailleurs, dans cette configuration, une efficacité d'extraction de 50% environ (rapport entre la puissance lumineuse totale rayonnée en champ lointain, et la puissance lumineuse émise initialement par la structure émissive 4, à l'intérieur des matériaux formant la LED 1).

Sur la figure 7, on a aussi représenté, à titre de comparaison, l'intensité lumineuse l' obtenue en champ lointain, en fonction de l'angle φ, pour une LED identique à celle de la figure 2 mais dépourvue de la structure de contact tridimensionnelle mentionnée plus haut (et sans les trous 13 pratiqués dans la couche 3). Ce cas correspond plus précisément à une surface supérieure plane, recouverte d'un isolant, sauf en périphérie où elle est recouverte par des pattes de contact telles que celle de la figure 1 (afin de pourvoir alimenter électriquement la LED). Chaque patte de contact s'étend sur environ 15% de la largeur totale de la surface supérieure, largeur qui est, là aussi, égale à environ 1,6 fois la longueur d'onde moyenne λ. Comme on peut le constater pour cet exemple, le type de connexion électrique de l'art antérieur, mis en œuvre dans la LED 1" de la figure 1, est nettement moins favorable que celui proposé ici, en termes de directivité. En effet, la courbe l'(φ) a une largeur totale à mi-hauteur d'environ 90 degrés (on notera par ailleurs que le profil l' a été dilaté verticalement - dans le sens des ordonnées - pour pouvoir être comparé visuellement au profil I ; mais en fait, les valeurs d'intensité l' sont nettement plus faibles que celle du profil I, en plus d'être réparties sur une largeur angulaire plus importante).

Dans le cas de la figure 2, les motifs présentés par la surface supérieure 30 sont des motifs en creux 13, en l'occurrence des trous cylindriques remplis du premier matériau, métallique. Mais, comme déjà indiqué ne faisant pas partie de l'invention, ces motifs peuvent aussi être des motifs en saillie 130 (figure 4), et différentes formes de motif et de maille peuvent être envisagées pour ce réseau, notamment en fonction de la forme souhaitée pour le faisceau lumineux émis.

Quatre types de réseaux différents, correspondant à quatre variantes du premier mode de réalisation de la LED 1 ; 100, sont représentés à titre d'exemple sur les figures.

La première variante est celle représentée sur les figures 2 et 3. Dans ce cas, comme déjà indiqué, les motifs sont des trous cylindriques 13 remplis du premier matériau, métallique. Le réseau est un réseau bidimensionnel (c'est-à-dire un réseau dans lequel le motif 13 est répété périodiquement dans deux directions différentes du plan du réseau). En l'occurrence, il s'agit d'un réseau triangulaire, dont la maille élémentaire est un triangle équilatéral.

Les figures 4 et 5 montrent une deuxième variante ne faisant pas partie de l'invention, dans laquelle les motifs sont, comme déjà indiqué, des motifs en saillie 130, en l'occurrence des piliers cylindriques. Le réseau est là aussi un réseau triangulaire.

La figure 6 montre une troisième variante dans laquelle le réseau a une maille carrée et dans lequel les motifs répétés périodiquement sont des motifs en creux, en l'occurrence des trous cylindriques 23 remplis du premier matériau, métallique (comme pour la première variante).

La figure 9 montre une quatrième variante, similaire à la première variante mais dans laquelle les inclusions métalliques 32 qui remplissent les motifs en creux 13 s'étendent au-delà du plan avant P_{F} qui délimite la couche supérieure 3. Ces inclusions métalliques 32 s'étendent jusque dans la couche de contact 31, formée du deuxième matériau (dont on rappelle qu'il est conducteur et transparent). Pour cette quatrième variante, les motifs 13 sont des motifs en creux identiques à ceux de la première variante, et répartis de la même manière (réseau triangulaire).

D'autres types de réseaux bidimensionnels, par exemple hexagonal (réseau en nids d'abeilles), ou correspondant à un pavage d'Archimède, sont envisageables, selon les caractéristiques souhaitées pour le faisceau lumineux extrait. Et, comme indiqué plus haut, le réseau peut aussi être un réseau quasi-périodique. Ce dernier cas est plus particulièrement adapté à des « macroLEDs », ayant des dimensions latérales supérieures à 10 microns, par exemple.

Quelle que soit la forme des motifs, et de la maille, on pourra prévoir, comme ici, un taux de remplissage τ_{F} par le réseau métallique inférieur à 50%, voire inférieur à 30% ou même inférieur à 20%. En pratique ce taux de remplissage pourra par exemple être compris entre 3 et 20 %.

Le taux de remplissage *τ_{F}* est défini comme suit. En projection sur un plan parallèle aux couches 2, 3, les motifs en creux 13, 23, ou l'espace 131 situé entre les motifs en saillie 130, occupent une aire appelée aire en retrait *A_{R}* (il s'agit en quelque sorte de l'aire frontale totale des zones remplies par le premier matériau conducteur). Par exemple, dans le cas de la figure 3, où le réseau comprend N trous cylindriques ayant chacun un diamètre D, l'aire en retrait *A_{R}* vaut *N* × *πD*²/4*.* Quoi qu'il en soit, le taux de remplissage *τ_{F}* est égal à l'aire en retrait *A_{R}*, divisée par l'aire frontale totale *A_{T}* de la surface supérieure 30 : *τ_{F} = A_{R}*/*A_{T}.*

A titre de comparaison, pour des cristaux photoniques réalisés en matériau diélectrique (au lieu d'être réalisés en métal), les taux de remplissage employés sont généralement proches de 50% (afin d'optimiser l'efficacité d'extraction).

Le taux de remplissage a donc une valeur relativement basse, ici, par rapport à des cristaux photoniques en matériaux diélectriques. Pour le réseau métallique employé ici, ce taux de remplissage modéré (typiquement 3 à 20%) permet d'augmenter l'efficacité d'extraction.

Au lieu d'être traduit par le taux de remplissage τF, qui est surfacique, la présence plus ou moins importante des motifs 13 sur la surface 30 peut être traduite par une fraction d'occupation FF (linéique) égale à :
- la dimension transverse des motifs en question, par exemple leur diamètre D lorsque ces motifs sont des trous cylindriques,
- divisée par le pas p du réseau,
soit FF= D/p.

Le taux de remplissage assez faible prévu pour le réseau métallique d'extraction (qui forme ici la structure de contact tridimensionnelle), se traduit alors aussi par des valeurs réduites de fraction d'occupation FF. Plus précisément, on pourra prévoir, comme ici, que la fraction d'occupation FF soit inférieure à 40%, par exemple comprise entre 20% et 40 %.

La figure 8A montre l'influence de la fraction d'occupation FF (exprimée en %) sur l'efficacité d'extraction ER (en unité arbitraire). Sur cette figure, l'efficacité d'extraction ER a été déterminée par simulation numérique, pour des inclusions en Aluminium (le caractère non-parfaitement réfléchissant de l'aluminium ayant été pris en compte), la hauteur h valant 160 nm tandis que le pas p du réseau vaut 200 nm (le diamètre D variant quant à lui, pour faire varier la fraction d'occupation FF). Comme on peut le voir sur cet exemple, l'efficacité d'extraction ER chute lorsque la fraction d'occupation FF devient supérieure à 40% environ. Et lorsque la fraction d'occupation est supérieure à environ deux-tiers, le rayonnement produit n'est quasiment plus extrait, et reste piégé dans la structure, où il est absorbé du fait du caractère imparfaitement réfléchissant des inclusions métalliques 12.

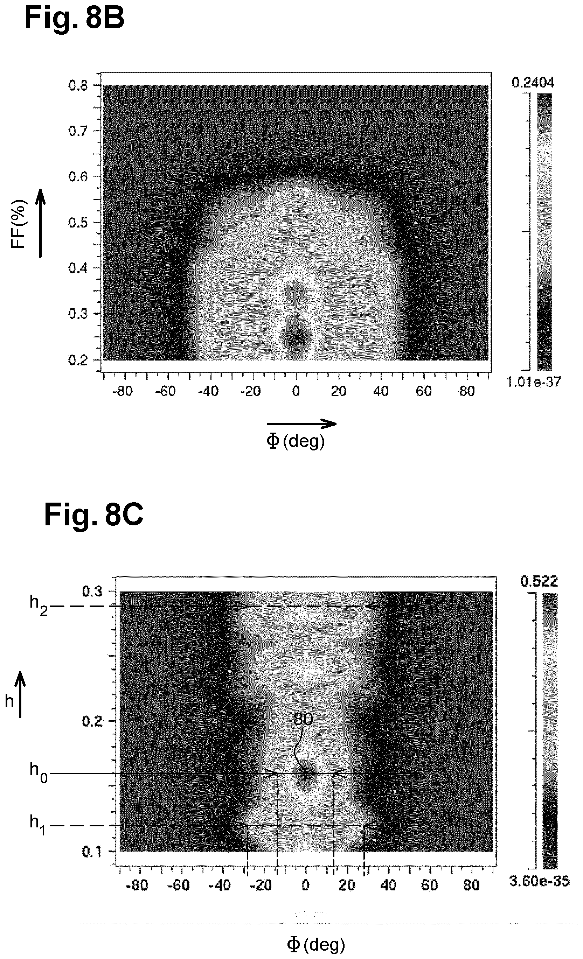

La figure 8B montre quant à elle l'influence de la fraction d'occupation FF des motifs sur la directivité en champ lointain, dans le cas de la LED 1 des figures 2 et 3. Cette figure rassemble, sous la forme d'un graphe bidimensionnel, plusieurs profils d'intensité lumineuse en champ lointain tel que celui de la figure 7, ces profils correspondant à différentes valeurs de la fraction d'occupation FF. L'axe des abscisses correspond à l'angle φ (angle repérant la direction de propagation considérée). Il est exprimé en degrés. L'axe des ordonnées correspond quant à lui à fraction d'occupation FF (exprimée en %). Pour un point donné dans le plan (φ, FF), l'intensité lumineuse est représentée par un niveau de gris. Dans ce graphe, une coupe à FF constant donne le profil d'intensité lumineuse I(φ) obtenu pour cette valeur de la fraction d'occupation.

Cette figure illustre qu'une valeur modérée de la fraction d'occupation, typiquement inférieure à 40 %, permet une bonne directivité de l'émission. En effet, sur cette figure, on constate que l'émission est directive pour FF inférieure à 40% tandis qu'un épatement (élargissement) du profil d'émission est observé pour les valeurs de FF supérieures à 40% environ.

L'extension verticale h des motifs 13, 23, 130, c'est-à-dire l'extension de ces motifs selon une direction perpendiculaire aux couches 2, 3, est un autre paramètre ayant une influence notable sur les propriétés d'extraction du réseau, notamment en ce qui concerne la directivité du rayonnement émis en champ lointain. Pour les motifs en creux 13, 23, l'extension verticale h est la profondeur des motifs, et pour les motifs en saillie 130, il s'agit de la hauteur de ces motifs.

La figure 8C montre l'influence de l'extension verticale h des motifs sur la directivité en champ lointain, dans le cas de la LED 1 des figures 2 et 3.

Cette figure rassemble, sous la forme d'un graphe bidimensionnel, plusieurs profils d'intensité lumineuse en champ lointain tel que celui de la figure 7, ces profils correspondant à différentes valeurs de l'extension verticale h. L'axe des abscisses correspond à l'angle φ, exprimé en degrés. L'axe des ordonnées correspond quant à lui à l'extension verticale h des motifs en creux 13, en unité arbitraire. Pour un point donné dans le plan (φ, h), l'intensité lumineuse est représentée par un niveau de gris. Dans ce graphe, une coupe à h constant donne le profil d'intensité lumineuse I(φ) obtenu pour cette valeur de l'extension verticale.

On peut voir sur cette figure que l'extension verticale h a effectivement une influence assez importante sur la directivité du rayonnement émis en champ lointain. On constate par exemple que la directivité est bien meilleure pour la valeur ho ~ 0,16 que pour la valeur h1 ~ 0,12 ou h2 ~ 0,29. Pour h=ho (cas pour lequel le rapport d'aspect RA des motifs vaut 3), le profil d'intensité présente un pic central 80 intense et étroit (avec une largeur totale à mi-hauteur d'environ 30 degrés), intéressant pour certains types d'applications.

En pratique, ce réseau d'extraction conduit à une émission relativement directive lorsque l'extension verticale des motifs est assez importante, par exemple de l'ordre du pas p du réseau. Pour obtenir une émission directive, on peut donc prévoir par exemple, comme ici, que l'extension verticale h soit supérieure ou égale à la moitié du pas p du réseau, de préférence comprise entre 0,5 fois et 1 fois le pas p du réseau, ou entre 0,5 fois et 1,5 fois le pas p du réseau.

Ici, les inclusions 12 ; 32 ont donc une forme étroite. Elles forment des antennes assez minces pénétrant en profondeur dans le haut de la couche supérieure 3, pour extraire de cette couche le rayonnement lumineux produit qui, sinon, resterait en bonne partie confiné dans cette couche. Les inclusions 12 ; 32 ont en particulier un rapport d'aspect R_{A} supérieur ou égal à 2, par exemple compris entre 2 et 4, voire entre 2 et 3,5. Ce rapport d'aspect R_{A} étant égal à l'extension verticale de chacune de ces inclusions 12 ; 32, divisé par une dimension transverse de l'inclusion 12 (dans un plan parallèle aux couches), par exemple divisée par son diamètre D, ou par sa largeur.

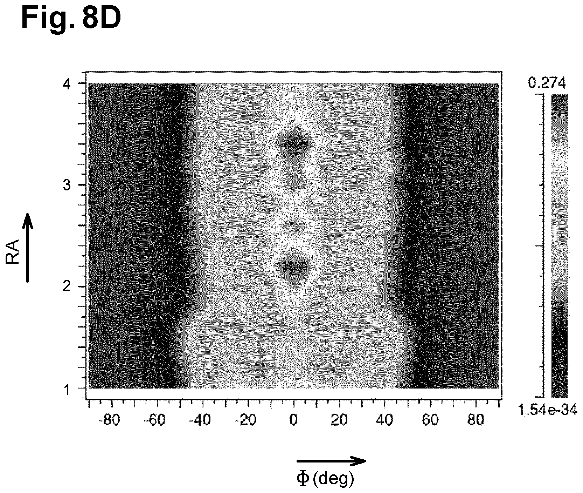

La figure 8D est similaire à la figure 8C, mais elle est obtenue pour un métal réel, avec pertes, alors que la figure 8C montre des résultats de simulation correspondant à un métal parfait (sans pertes). La configuration simulée pour obtenir cette figure correspond à un pas p de 200 nm et à des inclusions en Aluminium. Pour obtenir cette figure, simulation a été réalisée pour plusieurs valeur de la hauteur h des inclusions 12, afin de faire varier le rapport d'aspect R_{A} variant de 1,2 à 4. Sur cet exemple, on constate bien qu'un rapport d'aspect supérieur à 2, par exemple compris entre 2 et 3,5 (ce qui ici correspond d'ailleurs à un rapport h/p compris entre 0,5 et 0,9), permet d'obtenir une émission directive.

Le fait que les inclusions 12, 32 ou l'inclusion 120, soient relativement profondes et étroites est intéressant aussi du point de vue électrique, car cela contribue à augmenter l'aire sur laquelle est réalisé le contact électrique entre la couche supérieure 3 et la structure de contact 10 ; 110.

Comme déjà indiqué, la LED 100 de la figure 9 est similaire, et même identique à la LED 1 de la figure 1, si ce n'est que les inclusions 32, formées du premier matériau électriquement conducteur, s'étendent au-delà du plan avant P_{F} qui délimite la couche supérieure 3. Ces inclusions 32 dépassent du plan avant P_{F}, et pénètrent ainsi dans la couche de contact 31, sur une hauteur e. Cette structure de contact 110, dans laquelle les antennes élémentaires formées par les inclusions 32 dépassent du plan avant PF, est favorable, en termes d'efficacités d'extraction.

Dans cette variante, la couche de contact 31 a une face supérieure plane (du côté opposé à la couche supérieure 3), et une surface inférieure qui n'est pas complètement plane puisqu'elle épouse les reliefs en saillie formés par la partie des inclusions 32 qui dépasse du plan avant P_{F}. A titre de comparaison, dans la variante de la figure 2, où les inclusions 12 s'arrêtent au ras du plan avant P_{F}, la couche de contact 11 a à la fois une face supérieure plane et une face inférieure plane.

Un autre paramètre qui influence l'efficacité d'extraction est l'épaisseur b de la couche isolante 7 qui sépare latéralement les couches 2 et 3 des parois verticales métalliques 8 (figure 2). En effet, ces parois jouent un rôle de réflecteur, et il est donc souhaitable d'ajuster l'épaisseur b de manière à ce que les interférences, causées par les réflexions sur ces parois, contribuent à augmenter l'efficacité d'extraction plutôt qu'à la diminuer. Il est ainsi souhaitable d'ajuster l'épaisseur b de manière à obtenir un déphasage donné (par exemple un déphasage nul), lorsque le rayonnement lumineux traverse la couche isolante 7, se réfléchit sur la paroi 8, puis traverse à nouveau la couche isolante 7.

Pour améliorer encore l'efficacité d'extraction, la LED 1 peut comprendre une couche anti-reflet 14 déposée sur la couche de contact 11. Ici, la couche anti-reflet 14 est d'un seul tenant. En variante, il pourrait toutefois s'agir d'un empilement formé de plusieurs sous-couches. Cette couche est anti-reflet en ce sens qu'elle est configurée de manière à réduire la puissance lumineuse rétroréfléchie, vers le cœur de la LED, par l'interface correspondant à la face supérieure de la couche de contact 11. L'épaisseur d de la couche anti-reflet est par exemple égale au quart d'une longueur d'onde λₒ, longueur d'onde qui est la longueur d'onde moyenne du rayonnement lumineux en question, dans la couche de contact 11. L'indice optique n₁₄ de la couche anti-reflet a une valeur intermédiaire entre l'indice optique nₒ de la couche de contact 11, et l'indice optique n₁ du milieu qui s'étend au-dessus de la couche anti-reflet (par exemple de la silice). Le matériau de la couche anti-reflet est par exemple choisi pour avoir un indice optique n₁₄ proche de la racine carrée du produit nₒ×n₁.

Du point de vue de sa forme d'ensemble, l'empilement des couches 2 et 3 est délimité latéralement par gravure profonde, et forme ainsi un mesa (c'est-à-dire une sorte d'ilot) réalisé sur la structure d'accueil de la LED 1 ; 100, structure d'accueil qui est elle-même supportée par le substrat. Pour les exemples représentés sur les figures, ce mesa a une section rectangulaire (il s'agit de la section du mesa selon un plan parallèle au substrat). La couche supérieure 3 a donc elle aussi une section rectangulaire.

En variante, le mesa en question pourrait toutefois avoir une section différente, par exemple une section triangulaire, hexagonale ou circulaire.

On choisira toutefois, de préférence, une section ayant des symétries qui sont les mêmes que celles du réseau métallique mentionné plus haut (en d'autres termes, une section ayant les mêmes invariances par symétrie que le réseau lui-même). On notera que cette condition est bien vérifiée, dans le cas représenté sur la figure 3. En effet, le réseau triangulaire correspondant à cette variante est bien symétrique par rapport aux axes X et Y qui repèrent les deux bords de la section rectangulaire du mesa. Pour ce réseau triangulaire, une section triangulaire ou hexagonale aurait aussi pu être employée (puisque le réseau et la section de la couche supérieure présenteraient alors tous deux les mêmes symétries). Ces deux derniers cas permettent avantageusement, pour l'ensemble du réseau, d'obtenir le même nombre d'éléments rayonnant selon les directions de hautes symétries du réseau (tous les 60° pour la maille triangulaire), puisqu'un réseau de maille triangulaire ou hexagonale s'inscrit parfaitement sur une face supérieure hexagonale.

Du point de vue électrique, la couche inférieure 2 est en contact, par sa surface inférieure 20, avec une électrode 5 conductrice. Cette électrode 5 est reliée électriquement à un circuit de contrôle, via un empilement d'interconnexion (non représenté). Quant à la couche supérieure 3, comme déjà indiqué, elle est en contact électrique avec la structure de contact 10 ; 110, qui joue le rôle d'une électrode d'alimentation. D'ailleurs, lorsque plusieurs LEDs adjacentes sont réalisées les unes à côtés des autres sur le même substrat, la couche de contact 11 ; 31 joue le rôle d'une anode commune ou d'une cathode commune à ces différentes LEDs (la couche de contact recouvrant l'ensemble de ces LEDs).

### Deuxième mode de réalisation : structure de contact tridimensionnelle réalisée sur la surface inférieure de la couche inférieure

Dans ce deuxième mode de réalisation, la structure de contact 5' forme une couche d'un seul tenant qui, du côté de la surface inférieure 20' de la LED 1', vient au contact de cette surface et épouse son relief tridimensionnel, en venant remplir les motifs en creux ou l'espace 131' entre les motifs en saillie 130'. De l'autre côté, la structure de contact 5' est délimitée par une face arrière 52' qui est plane, ou tout au moins plane sur la majeure partie de cette face.

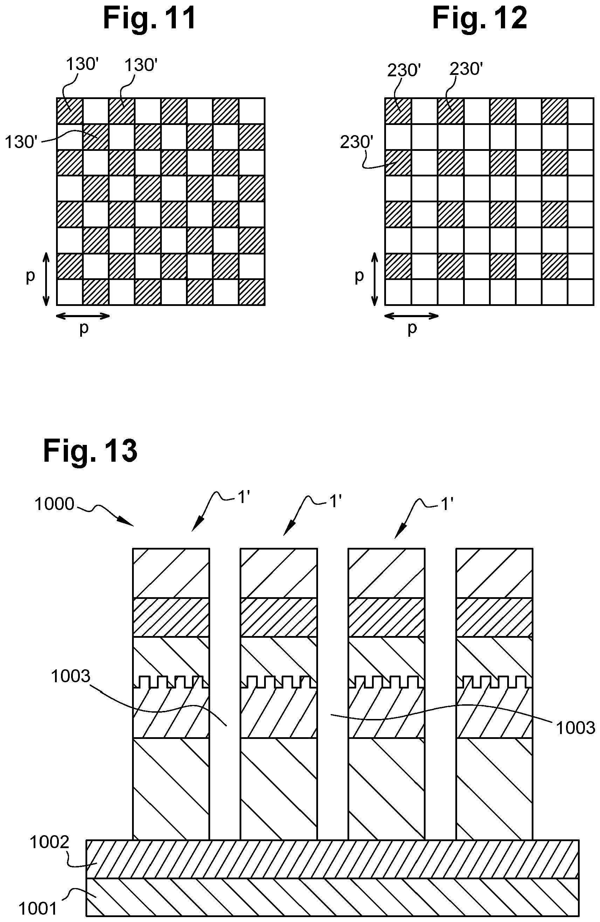

La figure 11 représente schématiquement la surface inférieure 20' de la LED 1' de la figure 10, vue de dessous. Pour cet exemple, les motifs sont des motifs en saillie 130'. Ces motifs correspondent aux parties hachurées, sur la figure 11. Ces motifs peuvent par exemple être cubiques ou pyramidaux. Ils sont répartis régulièrement sur la surface inférieure 20' en formant un réseau à maille carrée, en l'occurrence un réseau en échiquier dont une case carrée sur deux est occupée par un motif en saillie 130'.

Lorsque les motifs en saillie 130' sont cubiques, le gain, en termes de surface de contact, est alors égal à 3. Ce gain est égal à :
- l'aire totale de la surface sur laquelle la couche inférieure 2' est en contact avec la structure de contact 5', aire qui est donc égale ici à l'aire de la surface inférieure 20' (non-plane), divisés par
- l'aire frontale totale A_{T} de la surface inférieure 20'.

Toutefois, rien n'impose que la hauteur des motifs en saillie soit égale à la longueur des côtés des motifs et donc que le gain soit limité à 3. Dans le cas général le gain en surface pour des motifs parallélépipédiques de côté / dans le plan P_{R} et de hauteur h est égal à (4l²+8hl)/4l² dont la valeur est supérieure à 3 lorsque h>l. Sans perte de généralité, les exemples suivants sont donnés pour h=l.

Lorsque les motifs en saillie 130' sont pyramidaux (pyramide régulière à base carrée, avec un angle au sommet de 90 degrés), ce gain est égal à 1,2.

Dans une variante de ce deuxième mode de réalisation, les motifs 230' présentés par la surface inférieure de la LED 1' sont répartis de manière à former un réseau carré, mais moins dense qu'un réseau en échiquier (voir la figure 12 ; sur cette figure, les motifs 230' correspondent à nouveau aux zones hachurées). Pour ce type de pavage (appelé parfois « city block » en anglais), seulement une case carrée sur quatre est occupée par l'un des motifs 230'. Dans ce cas, pour des motifs cubiques, le gain en termes de surface de contact est égal à 2. Et pour des motifs pyramidaux, il est égal à 1,1.

En variante, les motifs présentés par la surface inférieure pourraient être des rainures, parallèles les unes aux autres. Dans ce cas, pour des rainures ayant un profil carré, avec un pas du réseau égal à deux fois la largeur d'une rainure, le gain en question est égal à 2. Et pour des rainures à profil en V ayant un angle au sommet de 90 degrés, contiguës les unes par rapport aux autres, ce gain est égal à 1,4.

En variante, d'autres types de motifs, en creux ou en saillie, et d'autres types de réseaux, uni ou bi-dimensionnels, peuvent être réalisés sur la surface inférieure de la LED.

Dans d'autres modes de réalisation, non représentés, on peut prévoir que les surfaces inférieure et supérieure de la LED soient toutes deux non-planes, avec des motifs en creux ou en saillie, et toutes deux pourvues d'une structure de contact tridimensionnelle telle que décrite plus haut. Dans ce cas, la surface supérieure est pourvue d'une structure de contact comprenant une couche de contact au moins partiellement transparente, comme pour le premier mode de réalisation présent plus haut.

La figure 13 représente schématiquement un écran d'affichage 1000 comprenant une matrice de LEDs telles que celle, 1', décrite ci-dessus, à un stade intermédiaire de sa fabrication.

### Procédé de fabrication

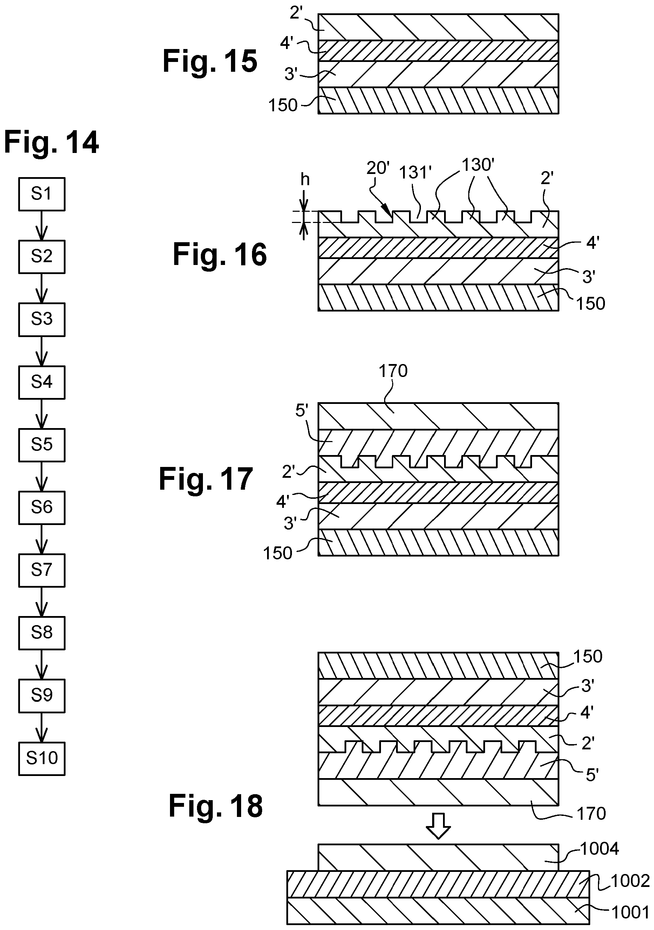

La figure 14 représente schématiquement une série d'étapes mises en œuvre lors d'un procédé de fabrication de l'écran d'affichage 1000.

Ce procédé comprend une étape S1 de réalisation d'un empilement comprenant la couche inférieure 2', la couche supérieure 3', et, entre les deux, la structure émissive 4', réalisée sous la forme d'un empilement de puits quantiques planaires (figure 15). A ce stade, les couches en question ne sont pas encore délimitées latéralement pour définir les différentes LEDs 1'. Elles sont donc d'un seul tenant, et s'étendent chacune sur quasiment toute la surface du futur écran 1000. Les puits quantiques planaires sont par exemple réalisés par épitaxie. Cet empilement est réalisé sur un substrat 150 servant de support temporaire à cette structure. La couche 2', destinée à devenir la couche inférieure des LEDs, est réalisée sur le dessus de cet empilement, du côté opposé au substrat 150 (car cet empilement est ensuite retourné, pour être reporté sur son substrat définitif ; voir les figures 17 et 18).

Le procédé comprend ensuite une étape S2 de gravure de la couche inférieure 2', pour lui donner la forme tridimensionnelle non-plane mentionnée plus haut, avec des motifs en creux ou en saillie (figure 16). A ce stade, la surface libre de la souche inférieure 2', appelée surface inférieure 20', est en fait située sur le dessus de l'empilement, ce qui permet sa gravure. La gravure en question est réalisée sur l'ensemble de la couche inférieure 2', non encore découpée. Elle est donc réalisée pour toutes les LEDs 1' en même temps.

La structure de contact 5' est ensuite réalisée, à l'étape S3, par dépôt d'une couche en matériau conducteur venant recouvrir la surface 20', précédemment texturée.

A l'étape suivante, S4, une couche de collage 170 est déposée sur la structure de contact 5'(figure 17). Cette couche de collage est formée ici d'un métal de collage, par exemple du titane Ti.

Le procédé comprend ensuite une étape S5 de report de l'empilement ainsi réalisé, sur un substrat final 1001 (qui forme un substrat d'accueil, pour la structure reportée sur celui-ci). Ce report est réalisé en retournant le substrat 150 et l'empilement qu'il supporte puis en le collant, du côté de la couche inférieure 2', sur une structure d'accueil 1002 des LEDs. Ce collage est réalisé notamment grâce à la couche de collage 170. Le collage peut être par exemple de type collage moléculaire, ou, autrement dit, collage direct. La structure d'accueil 1002 des LEDs peut elle même être recouverte d'une autre couche de collage, 1004, pour faciliter ce collage moléculaire (voir la figure 18). La structure d'accueil est réalisée sur le substrat final 1001 (figure 18). Elle comprend notamment l'empilement d'interconnexion mentionné plus haut, qui permet de piloter les différentes LEDs 1' indépendamment les unes des autres.

Après l'étape S5, le procédé comprend une étape S6 de retrait du substrat 150, qui servait de support temporaire.

Le procédé comprend ensuite une étape S9 de gravure profonde, au cours de la laquelle les différentes LEDs sont délimitées latéralement, en gravant des tranchées verticales 1003 dans l'empilement de couches 2', 3', 4' et 5' (figure 13). Cette gravure est par exemple une gravure ionique réactive de type RIE (de l'anglais « Reactive-Ion Etching »).

Le procédé comprend ensuite une étape S10 de réalisation de structures d'isolement, de protection et de raccordement de LEDs 1'. L'étape S10 comprend plusieurs sous-étapes au cours desquelles, entre autres, une couche isolante électriquement est déposée sur les flancs de tranchées 1003, des parois métalliques optionnelles, verticales, sont réalisées dans les tranchées, et une couche de protection est déposée sur le dessus des LEDs.

Pour réaliser une matrice de LEDs ayant aussi une structure de contact tridimensionnelles sur la surface supérieure de chaque LED, on ajoute au procédé de la figure 14 deux étapes supplémentaires S7 et S8 (non représentées), exécutées entre l'étape S6 de retrait du substrat 150 et avant l'étape S9 de délimitation des différentes LEDs. Au cours de l'étape S7, la surface supérieure de l'empilement est gravée pour lui donner une forme tridimensionnelle non plane, comme dans le premier mode de réalisation décrit plus haut. Puis, au cours de l'étape S8, on réalise la structure de contact en elle-même, en général en plusieurs sous-étapes du fait du caractère composite de cette structure, formée de deux matériaux conducteurs différents.

Pour réaliser une matrice de LEDs ayant aussi une structure de contact tridimensionnelles sur la surface supérieure de chaque LED, mais pas sur sa surface inférieure, on exécute un procédé similaire au procédé de la figure 14, mais dans lequel les étapes S2 et S3 sont omises tandis que les étapes S7 et S8 sont ajoutées, entre l'étape S6 et l'étape S9.

Comme illustré par le procédé qui vient d'être décrit, le type de LED 1 ; 100 ; 1' qui a été présenté plus haut se prête à une fabrication par des techniques planaires permettant de réaliser en même temps un grand nombre de LEDs adjacentes, ces LEDs n'étant délimitées les unes par rapport aux autres qu'en fin de procédé, lors de l'étape S9 (étape de découpe).

De plus, dans le cas où seule la surface inférieure 20' de chaque LED 1' est pourvue d'une structure de contact tridimensionnelle (telle que la structure 5'), l'étape S9 peut être réalisée sans alignement particulier des tranchées 1003 par rapport aux motifs 130' gravées sur la surface inférieure 20', ce qui facilite d'autant la fabrication.

En revanche, dans le cas où la surface supérieure 30 de chaque LED 1 ; 100 est pourvue d'une structure de contact tridimensionnelle (telle que la structure 10 ; 110), il peut être souhaitable d'aligner le masque de gravure employé à l'étape S9 par rapport aux motifs 13, 130, 23 gravés sur cette surface, pour un meilleur contrôle des propriétés optiques du réseau d'extraction formé par ces motifs.

## Revendications

1. Diode électroluminescente (1 ; 100) comprenant :
- une couche inférieure (2), formée au moins en partie d'un semi-conducteur dopé,
- une couche supérieure (3), formée au moins en partie d'un semiconducteur dopé, les couches inférieure et supérieure ayant des dopages de types opposés,
- une structure émissive (4), qui s'étend entre la couche inférieure (2) et la couche supérieure (3) et qui est apte à émettre un rayonnement lumineux lorsqu'elle est traversée par un courant électrique,
- la couche supérieure (3) étant délimitée par une surface supérieure (30), par laquelle sort une partie au moins dudit rayonnement lumineux,
- la couche inférieure (2) étant délimitée par une surface inférieure (20) d'injection de charges électriques,
- la surface supérieure (30) de la couche supérieure formant une structure tridimensionnelle non-plane présentant des motifs en creux (13), ladite surface (30) étant recouverte par une structure de contact (10) formée d'un ou plusieurs matériaux électriquement conducteurs, la structure de contact (10 ; 110) s'étendant contre ladite surface (30), en épousant cette surface (30) non-plane,
- **caractérisée en ce que**, pour chacun desdits motifs, un rapport d'aspect, égal à l'extension (h) dudit motif selon une direction (Z) perpendiculaire auxdites couches (2, 3), divisée par une dimension transverse (D) dudit motif dans un plan parallèle auxdites couches (2, 3), ladite dimension étant représentative de la taille du motif, est supérieur ou égal à 2.

2. Diode électroluminescente (1 ; 100) selon la revendication précédente, dans laquelle la structure de contact (10) remplit les motifs en creux (13 ; 23).

3. Diode électroluminescente (1 ; 100) selon l'une des revendications précédentes, dans laquelle lesdits motifs (13 ; 23), répétés régulièrement, forment un réseau périodique de pas p, ou un réseau quasi-périodique.

4. Diode électroluminescente (1 ; 100) selon la revendication précédente dans laquelle, lesdits motifs (13 ; 23) formant ledit réseau périodique de pas p, pour chacun desdits motifs, un rapport égal à ladite dimension transverse (D) dudit motif divisée par le pas p du réseau est compris entre 20% et 40%.

5. Diode électroluminescente (1 ; 100) selon l'une des revendications précédentes, occupant, dans un plan parallèle aux couches (2, 3), une aire totale inférieure à 100 microns carrés, voire inférieure à 10 microns carrés.

6. Diode électroluminescente (1 ; 100) selon l'une des revendications précédentes dans laquelle la structure de contact (10 ; 110) comprend :
- un premier matériau électriquement conducteur, qui remplit les motifs en creux (13 ; 23), et
- une couche de contact (11 ; 31) formée d'un deuxième matériau électriquement conducteur qui est au moins partiellement transparent pour ledit rayonnement lumineux, la couche de contact (11 ; 31) recouvrant ladite surface supérieure (30) et venant au contact du premier matériau électriquement conducteur.

7. Diode électroluminescente (1 ; 100) selon la revendication précédente, dans laquelle le premier matériau électriquement conducteur est réfléchissant pour ledit rayonnement lumineux.

8. Diode électroluminescente (100) selon l'une des revendications 6 ou 7, dans laquelle la surface supérieure (30), qui forme ladite structure tridimensionnelle, s'étend entre un plan avant (P_{F}) et un plan arrière (P_{R}) situé en retrait, les plans avant et arrière étant parallèles auxdites couches (2, 3), et dans lequel le premier matériau conducteur, qui remplit les motifs en creux (13), forme une ou des inclusions (32) qui s'étendent au-delà dudit plan avant (P_{F}), jusque dans la couche de contact (31).

9. Diode électroluminescente (1 ; 100) selon l'une des revendications précédentes, dans laquelle :
- la surface supérieure (30) occupe, en projection sur un plan parallèle auxdites couches (2, 3), une aire frontale totale A_{T},
- les motifs en creux (13 ; 23) occupent, en projection sur un plan parallèle auxdites couches, une aire en retrait A_{R},
- et dans laquelle un taux de remplissage, égal à l'aire en retrait A_{R} divisée par l'aire frontale totale A_{T}, est inférieur à 30%.

10. Diode électroluminescente (1) selon l'une des revendications précédentes, comprenant une couche anti-reflet (14) qui s'étend sur la couche de contact (11).

11. Diode électroluminescente selon l'une des revendications précédentes, dans laquelle ladite surface supérieure et ladite surface inférieure forment chacune une structure tridimensionnelle non-plane présentant des motifs en creux, recouverte par une structure de contact.

12. Diode électroluminescente (1 ; 100) selon l'une des revendications précédentes, dans laquelle lesdits motifs (13 ; 23) ont, selon au moins une direction, une dimension supérieure à 0,1 micron.

13. Ecran d'affichage comprenant une matrice de diodes électroluminescentes conformes chacune à l'une quelconque des revendications précédentes.

14. Procédé de fabrication d'une diode électroluminescente (1 ; 100), comprenant les étapes suivantes :
- (S1) réalisation d'un empilement comprenant :
∘ une couche inférieure (2), formée au moins en partie d'un semiconducteur dopé,
∘ une couche supérieure (3), formée au moins en partie d'un semiconducteur dopé, les couches inférieure et supérieure ayant des dopages de types opposés, et
∘ une structure émissive (4) qui s'étend entre la couche inférieure et la couche supérieure et qui est apte à émettre un rayonnement lumineux lorsqu'elle est traversée par un courant électrique,
- (S5) report de l'empilement ainsi réalisé sur un substrat final, la couche inférieure (2) étant située du côté du substrat,
- le procédé comprenant en outre les étapes suivantes :
∘ (S7) gravure d'une surface supérieure (30) de la couche supérieure (3), pour former une structure tridimensionnelle non-plane présentant des motifs en creux (13 ; 23), chacun desdits motifs ayant un rapport d'aspect, égal à l'extension (h) dudit motif selon une direction (Z) perpendiculaire auxdites couches (2, 3), divisée par une dimension transverse (D) dudit motif dans un plan parallèle auxdites couches (2, 3), ladite dimension étant représentative de la taille du motif, qui est supérieur ou égal à 2, et
∘ (S8 ; S3) sur la surface (30) ainsi gravée, réalisation d'une structure de contact (10) formée d'un ou plusieurs matériaux électriquement conducteurs, la structure de contact (10) s'étendant contre ladite surface (30) en épousant cette surface.

## Patentansprüche

1. Leuchtdiode (1; 100), umfassend:
- eine untere Schicht (2), die zumindest teilweise aus einem dotierten Halbleiter gebildet wird,
- eine obere Schicht (3), die zumindest teilweise aus einem dotierten Halbleiter gebildet wird, wobei die untere und die obere Schicht Dotierungen entgegengesetzter Art aufweisen,
- eine emittierende Struktur (4), die sich zwischen der unteren Schicht (2) und der oberen Schicht (3) erstreckt und eine Lichtstrahlung abgeben kann, wenn sie von einem elektrischen Strom durchströmt wird,
- wobei die obere Schicht (3) durch eine obere Oberfläche (30) begrenzt ist, durch die zumindest ein Teil der Lichtstrahlung austritt,
- wobei die untere Schicht (2) durch eine untere Oberfläche (20) zur Injektion elektrischer Ladungen begrenzt wird,
- wobei die obere Oberfläche (30) der oberen Schicht eine nicht-planare dreidimensionale Struktur mit vertieften Mustern (13) bildet, wobei die Oberfläche (30) mit einer Kontaktstruktur (10) bedeckt ist, die aus einem oder mehreren elektrisch leitenden Materialien gebildet ist, wobei sich die Kontaktstruktur (10; 110) gegen die Oberfläche (30) erstreckt und sich an diese nicht-planare Oberfläche (30) anpasst,
- **dadurch gekennzeichnet, dass** für jedes der Muster ein optisches Verhältnis, das gleich der Ausdehnung (h) des Musters in einer Richtung (Z) senkrecht zu den Schichten (2, 3) ist, geteilt durch eine Querabmessung (D) des Musters in einer Ebene parallel zu den Schichten (2, 3), wobei die Abmessung repräsentativ für die Größe des Musters ist, größer oder gleich 2 ist.

2. Leuchtdiode (1; 100) nach dem vorhergehenden Anspruch, in der die Kontaktstruktur (10) die vertieften Muster (13; 23) ausfüllt.

3. Leuchtdiode (1; 100) nach einem der vorhergehenden Ansprüche, in der die Muster (13; 23), die regelmäßig wiederholt werden, ein periodisches Gitter mit der Schrittweite p oder ein quasi-periodisches Gitter bilden.

4. Leuchtdiode (1; 100) nach dem vorhergehenden Anspruch, in der die Muster (13; 23) das periodische Gitter mit der Schrittweite p bilden, wobei für jedes der Muster ein Verhältnis, das gleich der Querabmessung (D) des Musters geteilt durch die Schrittweite p des Gitters ist, zwischen 20 % und 40 % liegt.

5. Leuchtdiode (1; 100) nach einem der vorhergehenden Ansprüche, die in einer Ebene parallel zu den Schichten (2, 3) eine Gesamtfläche von weniger als 100 Quadratmikron oder sogar weniger als 10 Quadratmikron einnimmt.

6. Leuchtdiode (1; 100) nach einem der vorhergehenden Ansprüche, in der die Kontaktstruktur (10; 110) umfasst:
- ein erstes elektrisch leitendes Material, das die vertieften Muster (13; 23) füllt, und
- eine Kontaktschicht (11; 31), die aus einem zweiten elektrisch leitenden Material gebildet ist, das zumindest teilweise transparent für die Lichtstrahlung ist, wobei die Kontaktschicht (11; 31) die obere Oberfläche (30) bedeckt und das erste elektrisch leitende Material berührt.

7. Leuchtdiode (1; 100) nach dem vorhergehenden Anspruch, in der das erste elektrisch leitende Material für die Lichtstrahlung reflektierend ist.

8. Leuchtdiode (100) nach einem der Ansprüche 6 oder 7, in der sich die obere Oberfläche (30), die die dreidimensionale Struktur bildet, zwischen einer vorderen Ebene (PF) und einer zurückgesetzten hinteren Ebene (PR) erstreckt, wobei die vordere und die hintere Ebene parallel zu den Schichten (2, 3) sind, und wobei das erste leitende Material, das die vertieften Muster (13) füllt, einen oder mehrere Einschlüsse (32) bildet, die sich über die vordere Ebene (PF) hinaus bis in die Kontaktschicht (31) erstrecken.

9. Leuchtdiode (1; 100) nach einem der vorhergehenden Ansprüche, in der:
- die obere Oberfläche (30) in der Projektion auf eine Ebene parallel zu den Schichten (2, 3) eine Gesamtstirnfläche AT einnimmt,
- die vertieften Muster (13; 23) in der Projektion auf eine Ebene parallel zu den Schichten eine zurückgesetzte Fläche AR einnehmen,
- und in der ein Füllgrad, der gleich der zurückgesetzten Fläche AR geteilt durch die Gesamtstirnfläche AT ist, weniger als 30% beträgt.

10. Leuchtdiode (1) nach einem der vorhergehenden Ansprüche, mit einer Antireflexionsschicht (14), die sich über die Kontaktschicht (11) erstreckt.

11. Leuchtdiode nach einem der vorhergehenden Ansprüche, in der die obere Oberfläche und die untere Oberfläche 10 jeweils eine nicht-planare dreidimensionale Struktur mit vertieften Mustern bilden, die von einer Kontaktstruktur bedeckt ist.

12. Leuchtdiode (1; 100) nach einem der vorhergehenden Ansprüche, in der die Muster (13; 23) in mindestens einer Richtung eine Größe von mehr als 0,1 Mikron aufweisen.

13. Anzeigebildschirm mit einer Matrix aus Leuchtdioden, die jeweils einem der vorhergehenden Ansprüche entsprechen.

14. Verfahren zur Herstellung einer Leuchtdiode (1; 100), das die folgenden Schritte umfasst:
- (S1) Herstellen einer Schichtung, umfassend:
∘ eine untere Schicht (2), die zumindest teilweise aus einem dotierten Halbleiter gebildet wird,
∘ eine obere Schicht (3), die zumindest teilweise aus einem dotierten Halbleiter gebildet wird, wobei die untere und die obere Schicht Dotierungen entgegengesetzter Art aufweisen, und
∘ eine emittierende Struktur (4), die sich zwischen der unteren und der oberen Schicht erstreckt und die Lichtstrahlung abgeben kann, wenn sie von einem elektrischen Strom durchströmt wird,
- (S5) Übertragen der so hergestellten Schichtung auf ein endgültiges Substrat, wobei sich die untere Schicht (2) auf der Seite des Substrats befindet,
- wobei das Verfahren darüber hinaus die folgenden Schritte umfasst:
∘ (S7) Ätzen einer oberen Oberfläche (30) der oberen Schicht (3), um eine nicht-planare dreidimensionale Struktur mit vertieften Mustern (13; 23) zu bilden, wobei jedes der Muster ein optisches Verhältnis aufweist, das gleich der Ausdehnung (h) des Musters in einer Richtung (Z) senkrecht zu den Schichten (2, 3) geteilt durch eine Querabmessung (D) des Musters in einer Ebene parallel zu den Schichten (2, 3) ist, wobei die Abmessung repräsentativ für die Größe des Musters ist, die größer als oder gleich 2 ist, und
∘ (S8; S3) auf der so geätzten Oberfläche (30), Herstellen einer Kontaktstruktur (10), die aus einem oder mehreren elektrisch leitenden Materialien gebildet ist, wobei sich die Kontaktstruktur (10) gegen die Oberfläche (30) erstreckt und sich an diese anpasst.

## Claims

1. Light-emitting diode (1; 100) comprising:
- a lower layer (2), at least partially made of a doped semiconductor,
- an upper layer (3), at least partially made of a doped semiconductor, the lower and upper layers having dopings of opposite types,
- an emissive structure (4), that extends between the lower layer (2) and the upper layer (3) and that is suitable to emit a light radiation when an electric current passes through it,
- the upper layer (3) being delimited by an upper surface (30), through which a portion at least of said light radiation exits,
- the lower layer (2) being delimited by a lower surface (20) for injecting electric charges,
- the upper surface (30) of the upper layer forming a non-planar three-dimensional structure having hollow patterns (13), said surface (30) being covered by a contact structure (10) made of one or more electrically-conductive materials, the contact structure (10; 110) extending against said surface (30), conforming to this non-planar surface (30),
- **characterised in that**, for each of said patterns, an aspect ratio, equal to the extension (h) of said pattern in a direction (Z) perpendicular to said layers (2, 3), divided by a transverse dimension (D) of said pattern in a plane parallel to said layers (2, 3), said dimension being representative of the size of the pattern, is greater than or equal to 2.

2. Light-emitting diode (1; 100) according to the preceding claim, wherein the contact structure (10) fills the hollow patterns (13; 23).

3. Light-emitting diode (1; 100) according to one of the preceding claims, wherein said patterns (13; 23), regularly repeated, form a periodic lattice of pitch p, or a quasiperiodic lattice.

4. Light-emitting diode (1; 100) according to the preceding claim, said patterns (13; 23) forming said periodic lattice of pitch p, wherein, for each of said patterns, a ratio equal to said transverse dimension (D) of said pattern divided by the pitch p of the lattice is comprised between 20% and 40%.

5. Light-emitting diode (1; 100) according to one of the preceding claims, occupying, in a plane parallel to the layers (2, 3), a total area less than 100 square microns, or even less than 10 square microns.

6. Light-emitting diode (1; 100) according to one of the preceding claims wherein the contact structure (10; 110) comprises:
- a first electrically-conductive material, that fills the hollow patterns (13; 23), and
- a contact layer (11; 31) made of a second electrically-conductive material that is at least partially transparent for said light radiation, the contact layer (11; 31) covering said upper surface (30) and coming into contact with the first electrically-conductive material.

7. Light-emitting diode (1; 100) according to the preceding claim, wherein the first electrically-conductive material is reflective for said light radiation.

8. Light-emitting diode (100) according to one of claims 6 or 7, wherein the upper surface (30), that forms said three-dimensional structure, extends between a front plane (P_{F}) and a recessed rear plane (P_{R}), the front and rear planes being parallel to said layers (2, 3), and wherein the first conductive material, that fills the hollow patterns (13), forms one or more inclusions (32) that extend beyond said front plane (P_{F}), into the contact layer (31).

9. Light-emitting diode (1; 100) according to one of the preceding claims, wherein:
- the upper surface (30) occupies, in projection on a plane parallel to said layers (2, 3), a total front surface area A_{T},
- the hollow patterns (13; 23) occupy, in projection on a plane parallel to said layers, a recessed surface area A_{R},
- and wherein a filling rate, equal to the recessed surface area A_{R} divided by the total front surface area A_{T}, is less than 30%.

10. Light-emitting diode (1) according to one of the preceding claims, comprising an anti-reflective layer (14) that extends over the contact layer (11).

11. Light-emitting diode according to one of the preceding claims, wherein said upper surface and said lower surface each form a non-planar three-dimensional structure having hollow patterns, covered by a contact structure.

12. Light-emitting diode (1; 100) according to one of the preceding claims, wherein said patterns (13; 23) have, in one direction at least, a dimension greater than 0.1 micron.

13. Display screen comprising an array of light-emitting diodes each in accordance with any of the preceding claims.

14. Method for manufacturing a light-emitting diode (1; 100), comprising the following steps:
- (S1) making a stack comprising:
∘ a lower layer (2), at least partially made of a doped semiconductor,
∘ an upper layer (3), least partially made of a doped semiconductor, the lower and upper layers having dopings of opposite types, and
∘ an emissive structure (4) that extends between the lower layer and the upper layer and that is suitable to emit a light radiation when an electric current passes through it,
- (S5) transfer of the stack thus made on a final substrate, the lower layer (2) being located on the side of the substrate,
- the method further comprising the following steps:
∘ (S7) etching of an upper surface (30) of the upper layer (3), to form a non-planar three-dimensional structure having hollow patterns (13; 23), each of said patterns having an aspect ratio, equal to the extension (h) of said pattern in a direction (Z) perpendicular to said layers (2, 3), divided by a transverse dimension (D) of said pattern in a plane parallel to said layers (2, 3), said dimension being representative of the size of the pattern, which is greater than or equal to 2, and
∘ (S8; S3) on the surface (30) thus etched, making a contact structure (10) made of one or more electrically-conductive materials, the contact structure (10) extending against said surface (30), conforming to this surface.
